# EUROPEAN PATENT SPECIFICATION

(11) **EP 2 016 207 B1**
(45) Date of publication and mention of the grant of the patent: **10.01.2018**
(21) Application number: 07762101.9
(22) Date of filing: 10.05.2007
(51) Int. Cl.: C23C 18/38, C23C 18/48

(54) **PLATING SOLUTION FOR ELECTROLESS DEPOSITION OF COPPER**
BESCHICHTUNGSLÖSUNG FÜR STROMLOSE VERKUPFERUNG
SOLUTION DE PLACAGE POUR DÉPÔT AUTOCATALYTIQUE DE CUIVRE

(30) Priority: 11.05.2006 US 382906
(43) Date of publication of application: 21.01.2009
(73) Proprietor: Lam Research Corporation, Fremont, CA 94538 (US)
(72) Inventor: VASKELIS, Algirdas, 2011 Vilnius (LT); NORKUS, Eugenijus, 10221 Vilnius (LT); JACIAUSKIENE, Jane, 04206 Vilnius (LT); JAGMINIENE, Aldona, 10320 Vilnius (LT)
(74) Representative: Kontrus, Gerhard
(86) International application number: PCT/US2007/068691
(87) International publication number: WO 2007/134182

(56) References cited:
- US-A- 4 650 691
- US-A1- 2004 253 450
- US-A1- 2006 040 487
- VASKELIS A ET AL: "KINETICS OF ELECTROLESS COPPER DEPOSITION USING COBALT(II)-ETHYLENEDIAMINE COMPLEX COMPOUNDS AS REDUCING AGENTS", JOURNAL OF APPLIED ELECTROCHEMISTRY, SPRINGER, DORDRECHT, NL, vol. 32, no. 3, 1 March 2002 (2002-03-01), pages 297-303, XP001114901, ISSN: 0021-891X, DOI: 10.1023/A:1015599527638

## Description

### BACKGROUND

In the fabrication of semiconductor devices such as integrated circuits, memory cells, and the like, a series of manufacturing operations are performed to define features on semiconductor wafers ("wafers"). The wafers include integrated circuit devices in the form of multi-level structures defined on a silicon substrate. At a substrate level, transistor devices with diffusion regions are formed. In subsequent levels, interconnect metallization lines are patterned and electrically connected to the transistor devices to define a desired integrated circuit device. Also, patterned conductive layers are insulated from other conductive layers by dielectric materials.

To build an integrated circuit, transistors are first created on the surface of the wafer. The wiring and insulating structures are then added as multiple thin-film layers through a series of manufacturing process steps. Typically, a first layer of dielectric (insulating) material is deposited on top of the formed transistors. Subsequent layers of metal (e.g., copper, aluminum, etc.) are formed on top of this base layer, etched to create the conductive lines that carry the electricity, and then filled with dielectric material to create the necessary insulators between the lines.

Although copper lines are typically comprised of a PVD seed layer (PVD Cu) followed by an electroplated layer (ECP Cu), electroless chemistries are under consideration for use as a PVD Cu replacement, and even as a ECP Cu replacement. A process called electroless copper deposition can thus be used to build the copper conduction lines. During electroless copper deposition electrons are transferred from a reducing agent to the copper ions in the solution resulting in the deposition of reduced copper onto the wafer surface. The formulation of the electroless copper plating solution is optimized to maximize the electron transfer process involving the copper ions in solution.

Conventional formulations call for maintaining the plating solution at a high alkaline pH (i.e., pH > 9). The limitations with using highly alkaline copper plating solutions for electroless copper deposition are non-compatibility with positive photoresist on the wafer surface, longer induction times, and decreased nucleation density due to an inhibition by hydroxylation of the copper interface (which occurs in a neutral-to-alkaline environment). These are limitations that can be eliminated if the solution is maintained at an acidic pH environment. A. Vaskelis, E. Norkus and J. Jaciauskiene, (Journal of Applied Electrochemistry 32: 297-303, 2002) investigated an electroless copper deposition using Co(II)-ethylenediamine complexes as reducing agents in 0.4-1.2 M ethylenediamine solutions at 50 and 70°C. A complicated dependence of the process rate on pH, ethylenediamine concentration and temperature is therein reported. A copper deposition rate of up to 6 µm h⁻¹ (50-70°C) in relatively stable solutions could be (pH of about 6) can be achieved.

In view of the forgoing, there is a need for improved formulations of copper plating solutions that can be maintained in a low acidic pH environment for use in electroless copper deposition processes.

### SUMMARY

Broadly speaking, the present invention fills these needs by providing improved formulations of copper plating solutions that can be maintained in an acidic pH environment for use in electroless copper deposition processes. It should be appreciated that the present invention can be implemented in numerous ways, including as a method and a chemical solution. Several inventive embodiments of the present invention are described below.

According to the invention, an electroless copper plating solution is disclosed. The solution includes an aqueous copper salt component, an aqueous cobalt salt component, a triamine based complexing agent, and a pH-modifying substance in an amount sufficient to make the electroless copper plating solution acidic. The pH-modifying substance is an acid and/or a buffering agent. The acid is added to the plating solution in sufficient quantities to make the solution acidic with a pH ≤ 6.4, and/or the buffering agent is added to make the solution acidic with a pH ≤ 6.4 and to prevent changes to the resulting pH of the solution after adjustment.
In another embodiment, the electroless copper plating solution includes an aqueous copper salt component with a concentration range between about 0.001 molarity (M) to the salt solubility limit. In yet
another embodiment, the electroless copper plating solution includes an aqueous cobalt salt component with a concentration range between about 0.001 molarity (M) to the salt solubility limit. In still another embodiment, an electroless copper plating solution includes a complexing agent having a triamine group with a concentration range between about 0.005 molarity (M) to 10.0hm.

In another aspect of the invention, a method for preparing an electroless copper plating solution is disclosed. The method involves combining the aqueous copper salt component, a portion of the complexing agent component and the acid component of the plating solution into a first mixture. The aqueous cobalt salt component and the remainder of the complexing agent is combined into a second mixture. Prior to use in an electroless copper deposition operation, the first mixture and second mixture are combined.

### DETAILED DESCRIPTION

An invention is described for providing improved formulations of copper plating solutions that can be maintained in an acidic pH environment for use in electroless copper deposition processes. It will be obvious, however, to one skilled in the art, that the present invention may be practiced without some or all of these specific details. In other instances, well known process operations have not been described in detail in order not to unnecessarily obscure the present invention.

Electroless metal deposition processes used in semiconductor manufacturing applications are based upon simple electron transfer concepts. The processes involve placing a prepared semiconductor wafer into an electroless metal plating solution bath then inducing the metal ions in the solution to accept electrons from a reducing agent resulting in the deposition of the reduced metal onto the surface of the wafer. The success of the electroless metal deposition process is highly dependent upon the various physical (e.g., temperature, etc.) and chemical (e.g., pH, reagents, etc.) parameters of the plating solution. As used herein, a reducing agent is an element or compound in an oxidation-reduction reaction that reduces another compound or element. In doing so, the reducing agent becomes oxidized. That is, the reducing agent is an electron donor that donates an electron to the compound or element being reduced.

A complexing agent (i.e., chelators or chelating agent) is any chemical agent that can be utilized to reversibly bind to compounds and elements to form a complex. A salt is any ionic compound composed of positively charged cations (e.g., Cu²⁺, etc.) and negatively charged anions, so that the product is neutral and without a net charge. A simple salt is any salt species that contain only one kind of positive ion (other than the hydrogen ion in acid salts). A complex salt is any salt species that contains a complex ion that is made up of a metallic ion attached to one or more electron-donating molecules. Typically a complex ion consists of a metallic atom or ion to which is attached one or more electron-donating molecules (e.g., Cu(II)ethylenediamine²⁺, etc.). A protonized compound is one that has accepted a hydrogen ion (i.e., H⁺) to form a compound with a net positive charge.

A copper plating solution for use in electroless copper deposition applications is disclosed below. The components of the solution are a copper(II) salt, a cobalt(II) salt, and a polyamine-based complexing agent. In one exemplary embodiment, the copper plating solution is prepared using de-oxygenated liquids. Use of de-oxygenated liquids substantially eliminates oxidation of the wafer surfaces and nullifies any effect that the liquids may have on the redox potential of the final prepared copper plating solution.

In one embodiment, the copper(II) salt is a simple salt. Examples of simple copper(II) salts include copper(II) sulfate, copper (II) nitrate, copper(II) chloride, copper(II) tetrafluoroborate, copper(II) acetate, and mixtures thereof. It should be appreciated that essentially any simple salt of copper(II) can be used in the solution so long as the salt can be effectively solubilized into solution, be complexed by a polyamine-based complexing agent, and oxidized by a reducing agent in an acidic environment to result in deposition of the reduced copper onto the surface of the wafer.

In one embodiment, the copper(II) salt is a complex salt with a polyamine electron-donating molecule attached to the copper(II) ion. Examples of complex copper(II) salts include copper(II) ethylenediamine sulfate, bis(ethylenediamine)copper(II) sulfate, copper (II) dietheylenetriamine nitrate, bis(dietheylenetriamine)copper(II) nitrate, and mixtures thereof. It should be appreciated that essentially any complex salt of copper(II) attached to a polyamine molecule can be used in the solution so long as the resulting salt can be solubilized into solution, be complexed to a polyamine-based complexing agent, and oxidized by a reducing agent in an acidic environment to result in deposition of the reduced copper onto the surface of the wafer.

In one embodiment, the concentration of the copper(II) salt component of the copper plating solution is maintained at a concentration of between about 0.0001 molarity (M) and the solubility limit of the various copper(II) salts disclosed above. In another exemplary embodiment, the concentration of the copper(II) salt component of the copper plating solution is maintained at between about 0.01 M and 10.0 M. It should be understood that the concentration of the copper(II) salt component of the copper plating solution can essentially be adjusted to any value up to the solubility limit of the copper(II) salt as long as the resulting copper plating solution can effectuate electro less deposition of copper on a wafer surface during an electroless copper deposition process.

In one embodiment, the cobalt(II) salt is a simple cobalt salt. Examples of simple cobalt(II) salts include cobalt(II) sulfate, cobalt(II) chloride, cobalt(II) nitrate, cobalt(II) tetrafluoroborate, cobalt(II) acetate, and mixtures thereof. It should be understood that essentially any simple salt of cobalt(II) can be used in the solution so long as the salt can be effectively solubilized in the solution, be complexed to a polyamine-based complexing agent, and reduce a cobalt(II) salt in an acidic environment to result in the deposition of the reduced copper onto the surface of the wafer.

In another embodiment, the cobalt(II) salt is a complex salt with a polyamine electron-donating molecule attached to the cobalt(II) ion. Examples of complex cobalt(II) salts include cobalt(II) ethylenediamine sulfate, bis(ethylenediamine)cobalt(II) sulfate, cobalt(II) dietheylenetriamine nitrate, bis(dietheylenetriamine)cobalt(II) nitrate, and mixtures thereof. It should be understood that essentially any simple salt of cobalt(II) can be used in the solution so long as the salt can be effectively solubilized into solution, be complexed to a polyamine-based complexing agent, and reduce a copper(II) salt in an acidic environment to result in the deposition of the reduced copper onto the surface of the wafer.

In one embodiment, the concentration of the cobalt(II) salt component of the copper plating solution is maintained at between about 0.0001 molarity (M) and the solubility limit of the various cobalt(II) salt species disclosed above. In one exemplary embodiment, the concentration of the cobalt(II) salt component of the copper plating solution is maintained at between about 0.01 M and 1.0 M. It should be understood that the concentration of the cobalt(II) salt component of the copper plating solution can essentially be adjusted to any value up to the solubility limit of the cobalt(II) salt as long as the resulting copper plating solution can effectuate electroless deposition of copper on a wafer surface at an acceptable rate during an electroless copper deposition process.

The polyamine-based complexing agent could have been a diamine compound. Examples of diamine compounds that can be utilized for the solution include ethylenediamine, propylenediamine, 3-methylenediamine, and mixtures thereof. In the present invention, the polyamine-based complexing agent is a triamine compound. Examples of triamine compounds that can be utilized for the solution include diethylenetriamine, dipropylenetriamine, ethylene propylenetriamine, and mixtures thereof. It should be understood that essentially any triamine compound can be used as the complexing agent for the plating solution so long as the compound can complex with the free metal ions in the solution (i.e., copper(II) metal ions and cobalt(II) metal ions), be readily solubilized in the solution, and be protonized in an acidic environment. In one embodiment, other chemical additives including levelers (amine-conating compounds such as the azo dyes (i.e. Janus Green), accelerators (i.e., SPS, sulfopropyl sulfonate) and suppressors (i.e., PEG, polyethylene glycol) are included in the copper plating solution at low concentrations to enhance the application specific performance of the solution.

In another embodiment, the concentration of the complexing agent component of the copper plating solution is maintained at between about 0.0001 molarity (M) and the solubility limit of the various diamine-based or triamine-based complexing agent species disclosed above. In one exemplary embodiment, the concentration of the complexing agent component of the copper plating solution is maintained at between about 0.005 M and 10.0 M, but must be greater than the total metal concentration in solution.

Typically, the complexing agent component of a copper plating solution causes the solution to be highly alkaline and therefore somewhat unstable (due to too large a potential difference between the copper(II)-cobalt(II) redox couple). In one exemplary embodiment, an acid is added to the plating solution in sufficient quantities to make the solution acidic with a pH ≤ about 6.4. In another embodiment, a buffering agent is added to make the solution acidic with a pH ≤ about 6.4 and to prevent changes to the resulting pH of the solution after adjustment. In still another embodiment, an acid and/or a buffering agent is added to maintain the pH of the solution at between about 4.0 and 6.4. In yet another embodiment, an acid and/or a buffering agent is added to maintain the pH of the solution at between about 4.3 and 4.6. In one embodiment, the anionic species of the acid matches the respective anionic species of the copper(II) and cobalt(II) salt components of the copper plating solution, however it should be appreciated that the anionic species do not have to match.

Acidic copper plating solutions have many operational advantages over alkaline plating solutions when utilized in an electroless copper deposition application. An acidic copper plating solution can inhibit the generation of H₂ as the copper(II)-cobalt(II) redox reaction takes place within the solution. This reduces void or occlusion formation in the copper layer that is deposited on the wafer surface. Further, an acidic copper plating solution improves the adhesion of the reduced copper ions that are deposited on the wafer surface. This is often a problem observed with alkaline copper plating solutions due to the formation of hydroxyl-terminated groups, inhibiting the nucleation reaction and causing reduced nucleation density, larger grain growth and increased surface roughness. Still further, for applications such as direct patterning of copper lines by electroless deposition of copper through a patterned film, an acidic copper plating solution helps improve selectivity over the barrier and mask materials on the wafer surface, and allows the use of a standard positive resist photomask resin material that would normally dissolve in a basic solution.

In addition to the advantages discussed above, copper deposited using the acidic copper plating solutions exhibits lower pre-anneal resistance characteristics than with copper deposited using alkaline copper plating solutions. It should be appreciated that the pH of the copper plating solutions, as disclosed herein, can essentially be adjusted to any acidic (i.e., pH ≤ 7.0) environment so long as the resulting deposition rates of copper during the electroless copper deposition process is acceptable for the targeted application and the solution exhibits all the operational advantages discussed above. In general, as the pH of the solution is lowered (i.e., made more acidic), the copper deposition rate decreases. However, varying the choice of complexing agent (i.e., triamine-based compounds) plus the concentration of the copper (II) and cobalt(II) salts can help compensate for any reduction in copper deposition rate resulting from an acidic pH environment.

In one embodiment, the copper plating solution is maintained at a temperature between about 0°Celsius (°C) and 70°C during an electroless copper deposition process. In one exemplary embodiment, the copper plating solution is maintained at a temperature of between about 20°C and 70°C during the electroless copper deposition process. It should be appreciated that temperature impacts the nucleation density and deposition rate of copper (mainly, the nucleation density and deposition rate of copper is directly proportional to temperature) to the wafer surface during copper deposition. The deposition rate impacts the thickness of the resulting copper layer and the nucleation density impacts void space, occlusion formation within the copper layer, and adhesion of the copper layer to the underlying barrier material. Therefore, the temperature settings for the copper plating solution during the electroless copper deposition process would be optimized to provide dense copper nucleation and controlled deposition following the nucleation phase of the bulk deposition to optimize the copper deposition rate to achieve copper film thickness targets.

This invention will be further understood by reference to the following examples in Table 1, which include several embodiments of the present invention.

| **TABLE 1** | |
|---|---|
| **Plating Solution A (pH=4.3)** | **Plating Solution A Formulation** |
| 0.05M Cu(NO₃)₂ | 11.2 milliliters (mL) [H₂O] |
| 0.6M Diethylenetriamine | 1 mL [Cu(NO₃)₂ 1M] |
| 0.15M Co(NO₃)₂ | 3.5mL [HNO₃ 5M] |
| | 1.3 mL [Diethylenetriamine 99%] |
| | Argon Gas |
| | 3.0 mL [C_{O}(NO₃)₂ 1M] |
| | |
| **Plating Solution B (pH=4.6)** Cu(NO₃)₂ | **Plating Solution B Formulation** 0.05M 11.7 mL [H₂O] |
| 0.6M Diethylenetriamine | 1 mL [Cu(NO₃)₂ 1M] |
| 0.15M Co(NO₃)₂ | 3.0 mL [HNO₃ 5M] |
| | 1.3 mL [Diethylenetriamine 99%] |
| | Argon Gas |
| | 3.0 mL [Co(NO₃)₂ 1M] |

| **Plating Solution C (pH=5.4)** | **Plating Solution C Formulation** |
|---|---|
| 0.05M Cu(BF₄)₂ | 13.2 mL [H₂O] |
| 0.6M Diethylenetriamine | 1.0 mL [Cu(BF₄)₂ 1M] |
| 0.15M Co(BF₄)₂ | 1.0 mL [HBF₄ 5M] |
| | 1.3 mL [Diethylenetriamine 99%] |
| | Argon Gas |
| | 3.53 mL [Co(BF₄)₂ 1M] |
| | |
| **Plating Solution D (pH=6.15)** | **Plating Solution D Formulation** |
| 0.05M Cu(BF₄)₂ | 13.47 mL [H₂O] |
| 0.6M Diethylenetriamine | 1.0 mL [Cu(BF₄)₂ 1M] |
| 0.15M Co(BF₄)₂ | 0.7 mL [HBF₄ 5M] |
| | 1.3 mL [Diethylenetriamine 99%] |
| | Argon Gas |
| | 3.53 mL [Co(BF₄)₂ 1M] |
| | |
| | |

As shown above in Table 1, in one exemplary embodiment (i.e., Plating Solution A), a copper nitrate/diethylenetriamine plating solution is disclosed with a pH of 4.3 and including 0.05M Cu(NO₃)₂, 0.6M Diethylenetriamine, and 0.15M Co(NO₃)₂. In another embodiment (i.e., Plating Solution B), the copper nitrate/diethylenetriamine plating solution is disclosed with a pH of 4.6 and including 0.05M Cu(NO₃)₂, 0.6M Diethylenetriamine, and 0.15M Co(NO₃)₂. It should be understood that the concentrations of the Cu(NO₃)₂, Diethylenetriamine, and Co(NO₃)₂ components of the copper nitrate/diethylenetriamine plating solution can be adjusted to any value up to the solubility limit of the components so long as the resulting solution can effectuate an acceptable copper deposition rate for the pH setting of the solution.

In one exemplary embodiment of the present invention, the formulation (i.e. Plating Solution A Formulation) of Plating Solution A is disclosed. It should be appreciated that the order in which the various chemical components of a plating solution are mixed during formulation impacts the copper plating performance of the resulting solution. In this exemplary embodiment, a 20 milliliter (mL) batch of Plating Solution A is formulated by initially adding about 11.2 mL of water (H₂O) to an appropriately sized container followed by about 1.0 mL of 1M Cu(NO₃)₂ solution, about 3.5 mL of 5M HNO₃ solution and about 1.3 mL of Diethylenetriamine (99%). At this point in the formulation the copper ions released by the Cu(NO₃)₂ component are complexed with the Diethylenetriamine molecules in the mixture. The resulting mixture is then deoxygenated using an inert gas such as Argon gas introduced to the mixture prior to adding Co(NO₃)₂ solution to prevent the premature oxidation of the cobalt element of the Co(NO₃)₂ solution. It should be understood that Argon gas can be delivered to the mixture using any commercially available gas sparging system so long as the gas is delivered in sufficient quantities to deoxygenate the mixture to the required level for the electroless copper deposition application. It should be appreciated that other types of inert gas (e.g., N₂, etc.) can also be used as long as the gas does not interfere with the electroless copper deposition process. Finally, about 3.0 mL of Co(NO₃)₂ solution is added to the mixture to complete the formulation of Plating Solution A.

Continuing with Table 1, in another embodiment, the formulation (i.e. Plating Solution B Formulation) of Plating Solution B is disclosed. In this embodiment, a 20 milliliter (mL) batch of Plating Solution B is formulated by initially adding about 11.7 mL of water (H₂O) to an appropriately sized container followed by about 1.0 mL of 1M Cu(NO₃)₂ solution, about 3.0 mL of 5M HNO₃ solution and about 1.3 mL of Diethylenetriamine (99%). The resulting mixture is then deoxygenated using Argon gas introduced to the mixture prior to the addition of about 3.0 mL of 1M Co(NO₃)₂ solution to complete the formulation of Plating Solution B.

In one embodiment, an electroless copper plating solution is prepared by first premixing a portion of the complexing agent component with the copper salt component, acid component, and water into a into a first pre-mixed solution. The remaining portion of the complexing agent component is pre-mixed with the cobalt salt component into a second pre-mixed solution. The first premixed solution and second pre-mixed solution are then added into an appropriate container for final mixing into the final electroless copper plating solution prior to use in an electroless copper deposition operation.

Still referring to Table 1, in one embodiment (i.e., Plating Solution C), a copper(II) tetrafluoroborate/diethylenetriamine plating solution is disclosed with a pH of 5.4 and including 0.05M Cu(BF₄)₂, 0.6M Diethylenetriamine, and 0.15M Co(BF₄)₂. In another embodiment (i.e., Plating Solution D), the copper(II) tetrafluoroborate/diethylenetriamine plating solution is disclosed with a pH of 6.15 and including 0.05M Cu(BF₄)₂, 0.6M Diethylenetriamine, and 0.15M Co(BF₄)₂. It should be understood that the concentrations of the Cu(BF₄)₂, Diethylenetriamine, and Co(BF₄)₂ components of the copper tetrafluoroborate/diethylenetriamine plating solution can be adjusted to any value up to the solubility limit of the components so long as the resulting solution can effectuate an acceptable copper deposition rate for the pH setting of the solution.

In one embodiment, the formulation (i.e. Plating Solution C Formulation) of Plating Solution C is disclosed. In this embodiment, a 20.03 milliliter (mL) batch of Plating Solution C is formulated by initially adding about 13.2 mL of water (H₂O) to an appropriately sized container followed by about 1.0 mL of 1M Cu(BF₄)₂ solution, about 1.0 mL of 5M H BF₄ solution and about 1.3 mL of Diethylenetriamine (99%). The resulting mixture is then deoxygenated using Argon gas introduced to the mixture prior to the addition of about 3.53 mL of 0.85M Co(BF₄)₂ solution to complete the formulation of Plating Solution C.

Remaining with Table 1, in another embodiment, the formulation (i.e. Plating Solution D Formulation) of Plating Solution D is disclosed. In this embodiment, a 20.0 milliliter (mL) batch of Plating Solution D is formulated by initially adding about 13.47 mL of water (H₂O) to an appropriately sized container followed by about 1.0 mL of 1M Cu(BF₄)₂ solution, about 0.7 mL of 5M H BF₄ solution and about 1.3 mL of Diethylenetriamine (99%). The resulting mixture is then deoxygenated using Argon gas introduced to the mixture prior to the addition of about 3.53 mL of 0.85M Co(BF₄)₂ solution to complete the formulation of Plating Solution D.

## Claims

1. An electroless copper plating solution, comprising:
an aqueous copper salt component;
an aqueous cobalt salt component;
a complexing agent that is a triamine compound; and
a pH-modifying substance in an amount sufficient to make the electroless copper plating solution acidic, wherein the pH-modifying substance is an acid and/or a buffering agent,
wherein the acid is added to the plating solution in sufficient quantities to make the solution acidic with a pH ≤ 6.4, and/or
the buffering agent is added to make the solution acidic with a pH ≤ 6.4 and to prevent changes to the resulting pH of the solution after adjustment.

2. The electroless copper plating solution, as recited in claim 1, wherein, the aqueous copper salt component is selected from a group of complex copper salts consisting of ethylenediamine copper(II) sulfate, bis(ethylenediamine) copper(II) sulfate, diethylenetriamine copper(II) nitrate, and bis(diethylenetriamine) copper(II) nitrate.

3. The electroless copper plating solution, as recited in claim 1, wherein, the triamine compound is selected from a group consisting of diethylenetriamine, dipropylenetriamine, and ethylene propylenetriamine.

4. The electroless copper plating solution, as recited in claim 1, wherein, a pH of the electroless copper plating solution is between 4.3 and 4.6.

5. The electroless copper plating solution, as recited in claim 1, wherein the aqueous copper salt component having a concentration between 0.001 molarity to a solubility limit for the aqueous copper salt component.

6. The electroless copper plating solution, as recited in claim 5, wherein the pH- modifying substance is a buffer adjusting the electroless copper plating solution to a pH of between 4.0 and 6.4.

7. The electroless copper plating solution, as recited in claim 1 or claim 5, wherein, the pH- modifying substance is selected from a group consisting of sulfuric acid, nitric acid, hydrochloric acid, fluoroboric acid, and acetic acid.

8. The electroless copper plating solution, as recited in claim 1, wherein the aqueous cobalt salt component having a concentration between 0.001 molarity to a solubility limit for the aqueous cobalt salt component.

9. The electroless copper plating solution, as recited in claim 8, wherein, a pH of the electroless copper plating solution is between 4.0 and 6.4.

10. The electroless copper plating solution, as recited in claim 1, wherein the complexing agent has a concentration between 0.005 molarity to 10.0 molarity.

11. The electroless copper plating solution, as recited in claim 10, wherein, the electroless copper plating solution is prepared by mixing a first mixture with a second mixture, wherein,
the first mixture consists essentially of the aqueous copper salt component, the pH modifying substance, and a portion of the complexing agent; and
the second mixture consists essentially of the aqueous cobalt salt component and a remainder of the complexing agent.

12. The electroless copper plating solution, as recited in claim 10, wherein, the electroless copper plating solution is prepared by sequentially combining the aqueous copper salt component to a volume of water, then adding the pH-modifying substance to the aqueous copper salt component/water combination, thereafter adding the complexing agent, and lastly adding the aqueous cobalt salt component.

13. A method for preparing an electroless copper plating solution comprising:
combining an aqueous copper salt component, a portion of a complexing agent and an acid as a first component;
combining an aqueous cobalt salt component and a remaining portion of the complexing agent as a second component; and
mixing the first component and the second component prior to use in a deposition operation,
wherein the complexing agent is a triamine compound, and
wherin the acid is added to the plating solution in sufficient quantities to make the solution acidic with a pH ≤ 6.4.

14. The method for preparing an electroless copper plating solution, as recited in claim 13, wherein the aqueous copper salt component is selected from a group consisting of copper(II) sulfate, copper(II) nitrate, copper(II) chloride, copper(II) tetrafluoroborate, and copper(II) acetate.

15. The method for preparing an electroless copper plating solution, as recited in claim 13, wherein the aqueous cobalt salt component is selected from a group consisting of cobalt(II) sulfate, cobalt(II) nitrate, cobalt(II) chloride, cobalt(II) tetrafluoroborate, and cobalt(II) acetate.

## Patentansprüche

1. Lösung zur stromlosen Kupferplattierung, umfassend:
eine wässrige Kupfersalzkomponente;
eine wässrige Kobaltsalzkomponente;
einen Komplexbildner, bei dem es sich um eine Triaminverbindung handelt; und
eine pH-ändernde Substanz in einer ausreichenden Menge, um die Lösung zur stromlosen Kupferplattierung sauer zu machen, wobei die pH-ändernde Substanz eine Säure und/oder ein Puffermittel ist,
wobei die Säure der Plattierungslösung in ausreichenden Mengen zugesetzt wird, um die Lösung mit einem pH von ≤ 6,4 sauer zu machen, und/oder
das Puffermittel zugesetzt wird, um die Lösung mit einem pH von ≤ 6,4 sauer zu machen und um nach der Einstellung Veränderungen des resultierenden pH der Lösung zu verhindern.

2. Lösung zur stromlosen Kupferplattierung nach Anspruch 1, wobei die wässrige Kupfersalzkomponente aus einer Gruppe von komplexen Kupfersalzen ausgewählt wird, die aus Ethylendiamin-kupfer(II)-sulfat, Bis(ethylendiamin)kupfer(II)-sulfat, Diethylentriamin-kupfer(II)-nitrat und Bis(diethylentriamin)kupfer(II)-nitrat besteht.

3. Lösung zur stromlosen Kupferplattierung nach Anspruch 1, wobei die Triaminverbindung aus einer Gruppe ausgewählt ist, die aus Diethylentriamin, Dipropylentriamin und Ethylenpropylentriamin besteht.

4. Lösung zur stromlosen Kupferplattierung nach Anspruch 1, wobei ein pH der Lösung zur stromlosen Kupferplattierung zwischen 4,3 und 4,6 liegt.

5. Lösung zur stromlosen Kupferplattierung nach Anspruch 1, wobei die wässrige Kupfersalzkomponente eine Konzentration zwischen einer Molarität von 0,001 und einer Löslichkeitsgrenze für die wässrige Kupfersalzkomponente aufweist.

6. Lösung zur stromlosen Kupferplattierung nach Anspruch 5, wobei die pH-ändernde Substanz ein Puffer ist, der die Lösung zur stromlosen Kupferplattierung auf einen pH zwischen 4,0 und 6,4 einstellt.

7. Lösung zur stromlosen Kupferplattierung nach Anspruch 1 oder Anspruch 5, wobei die pH-ändernde Substanz aus einer Gruppe ausgewählt ist, die aus Schwefelsäure, Salpetersäure, Salzsäure, Fluorborsäure und Essigsäure besteht.

8. Lösung zur stromlosen Kupferplattierung nach Anspruch 1, wobei die wässrige Kobaltsalzkomponente eine Konzentration zwischen einer Molarität von 0,001 und einer Löslichkeitsgrenze für die wässrige Kobaltsalzkomponente aufweist.

9. Lösung zur stromlosen Kupferplattierung nach Anspruch 8, wobei ein pH der Lösung zur stromlosen Kupferplattierung zwischen 4,0 und 6,4 liegt.

10. Lösung zur stromlosen Kupferplattierung nach Anspruch 1, wobei der Komplexbildner eine Konzentration zwischen einer Molarität von 0,005 und einer Molarität von 10,0 aufweist.

11. Lösung zur stromlosen Kupferplattierung nach Anspruch 10, wobei die Lösung zur stromlosen Kupferplattierung hergestellt wird, indem ein erstes Gemisch mit einem zweiten Gemisch gemischt wird, wobei
das erste Gemisch im Wesentlichen aus der wässrigen Kupfersalzkomponente, der pH-ändernden Substanz und einem Teil des Komplexbildners besteht; und
das zweite Gemisch im Wesentlichen aus der wässrigen Kobaltsalzkomponente und einem Rest des Komplexbildners besteht.

12. Lösung zur stromlosen Kupferplattierung nach Anspruch 10, wobei die Lösung zur stromlosen Kupferplattierung hergestellt wird, indem sequenziell die wässrige Kupfersalzkomponente mit einem Volumen Wasser kombiniert wird, anschließend die pH-ändernde Substanz zu der Kombination aus wässriger Kupfersalzkomponente und Wasser zugesetzt wird, danach der Komplexbildner zugesetzt wird und zuletzt die wässrige Kobaltsalzkomponente zugesetzt wird.

13. Verfahren zur Herstellung einer Lösung zur stromlosen Kupferplattierung, umfassend:
Kombinieren einer wässrigen Kupfersalzkomponente, eines Teils eines Komplexbildners und einer Säure als erste Komponente;
Kombinieren einer wässrigen Kobaltsalzkomponente und einem restlichen Teil des Komplexbildners als zweite Komponente; und
Mischen der ersten Komponente und der zweiten Komponente vor der Verwendung bei einem Abscheidungsvorgang,
wobei der Komplexbildner eine Triaminverbindung ist, und
wobei die Säure der Plattierungslösung in ausreichenden Mengen zugesetzt wird, um die Lösung mit einem pH von ≤ 6,4 sauer zu machen.

14. Verfahren zur Herstellung einer Lösung zur stromlosen Kupferplattierung nach Anspruch 13, wobei die wässrige Kupfersalzkomponente aus einer Gruppe ausgewählt ist, die aus Kupfer(II)-sulfat, Kupfer(II)-nitrat, Kupfer(II)-chlorid, Kupfer(II)-tetrafluorborat und Kupfer(II)-acetat besteht.

15. Verfahren zur Herstellung einer Lösung zur stromlosen Kupferplattierung nach Anspruch 13, wobei die wässrige Kobaltsalzkomponente aus einer Gruppe ausgewählt ist, die aus Kobalt(II)-sulfat, Kobalt(II)-nitrat, Kobalt(II)-chlorid, Kobalt(II)-tetrafluorborat und Kobalt(II)-acetat besteht.

## Revendications

1. Solution de cuivrage chimique autocatalytique contenant:
un composant aqueux contenant un sel de cuivre ;
un composant aqueux contenant un sel de cobalt ;
un agent complexant qui est un composé de triamine et
un modificateur de pH en quantité suffisante pour acidifier la solution de cuivrage chimique autocatalytique, le modificateur de pH étant un acide et/ou un tampon,
dans laquelle l'acide est ajouté à la solution de cuivrage en quantité suffisante pour l'acidifier à un pH ≤ 6,4, et/ou
le tampon est ajouté de façon à acidifier la solution à un pH ≤ 6,4 et à empêcher les changements du pH résultant de la solution après un ajustement.

2. Solution de cuivrage chimique autocatalytique selon la revendication 1, dans laquelle le composant aqueux contenant un sel de cuivre est choisi parmi un groupe de sels de cuivre complexes comprenant le sulfate d'éthylènediamine et cuivre (II), le sulfate de bis(éthylènediamine) et cuivre (II), le nitrate de diéthylènetriamine et cuivre (II) et le nitrate de bis (diéthylènetriamine) et cuivre (II).

3. Solution de cuivrage chimique autocatalytique selon la revendication 1, dans laquelle le composé de triamine est choisi parmi un groupe comprenant la diéthylènetriamine, la dipropylènetriamine et l'éthylène-propylènetriamine.

4. Solution de cuivrage chimique autocatalytique selon la revendication 1, dans laquelle le pH de la solution de cuivrage chimique autocatalytique est compris entre 4,3 et 4,6.

5. Solution de cuivrage chimique autocatalytique selon la revendication 1, dans laquelle le composant aqueux contenant un sel de cuivre a une concentration comprise entre une molarité de 0,001 et sa limite de solubilité pour le composant aqueux contenant un sel de cuivre.

6. Solution de cuivrage chimique autocatalytique selon la revendication 5, dans laquelle le modificateur de pH est un tampon qui ajuste la solution de cuivrage chimique autocatalytique à un pH compris entre 4,0 et 6,4.

7. Solution de cuivrage chimique autocatalytique selon la revendication 1 ou 5, dans laquelle le modificateur de pH est choisi dans un groupe comprenant l'acide sulfurique, l'acide nitrique, l'acide chlorhydrique, l'acide fluoborique et l'acide acétique.

8. Solution de cuivrage chimique autocatalytique selon la revendication 1, dans laquelle le composant aqueux contenant un sel de cobalt a une concentration comprise entre une molarité de 0,001 et sa limite de solubilité pour le composant aqueux contenant un sel de cobalt.

9. Solution de cuivrage chimique autocatalytique selon la revendication 8, dans laquelle le pH de la solution de cuivrage chimique autocatalytique est compris entre 4,0 et 6,4.

10. Solution de cuivrage chimique autocatalytique selon la revendication 1, dans lequel l'agent complexant a une concentration comprise entre une molarité de 0,005 et une molarité de 10,0.

11. Solution de cuivrage chimique autocatalytique selon la revendication 10, dans laquelle la solution de cuivrage chimique autocatalytique est préparée en mélangeant un premier mélange avec un deuxième mélange,
le premier mélange se composant pour l'essentiel du composant aqueux contenant un sel de cuivre, du modificateur de pH et d'une partie de l'agent complexant ; et
le deuxième mélange se composant pour l'essentiel du composant aqueux contenant un sel de cobalt et du reste de l'agent complexant.

12. Solution de cuivrage chimique autocatalytique selon la revendication 10, laquelle solution de cuivrage chimique autocatalytique est préparée en combinant successivement le composant aqueux contenant un sel de cuivre à un volume d'eau, puis en ajoutant le modificateur de pH à la combinaison de composant aqueux contenant un sel de cuivre et d'eau, puis en ajoutant l'agent complexant et pour finir le composant aqueux contenant un sel de cobalt.

13. Procédé pour préparer une solution de cuivrage chimique autocatalytique, comprenant :
la combinaison d'un composant aqueux contenant un sel de cuivre, d'une partie d'un agent complexant et d'un acide constituant le premier composant ;
la combinaison d'un composant aqueux contenant un sel de cobalt et du reste de l'agent complexant constituant un deuxième composant ; et
le mélange du premier composant et du deuxième composant avant l'utilisation dans une opération de dépôt,
dans lequel l'agent complexant est un composé de triamine et
dans lequel l'acide est ajouté à la solution de cuivrage en quantité suffisante pour acidifier la solution à un pH ≤ 6,4.

14. Procédé pour préparer une solution de cuivrage chimique autocatalytique selon la revendication 13, dans lequel le composant aqueux contenant un sel de cuivre est choisie parmi un groupe comprenant le sulfate de cuivre (II), le nitrate de cuivre (II), le chlorure de cuivre (II), le tétrafluoroborate de cuivre (II) et l'acétate de cuivre (II).

15. Procédé pour préparer une solution de cuivrage chimique autocatalytique selon la revendication 13, dans lequel le composant aqueux contenant un sel de cobalt est choisi parmi un groupe comprenant le sulfate de cobalt (II), le nitrate de cobalt (II), le chlorure de cobalt (II), le tétrafluoroborate de cobalt (II) et l'acétate de cobalt (II).
